Europäisches Patentamt

(19) European Patent Office

Office européen des brevets

(11) Numéro de publication : **0 273 803 B1**

(12) **FASCICULE DE BREVET EUROPEEN**

(45) Date de publication du fascicule du brevet :
**10.04.91 Bulletin 91/15**

(51) Int. Cl.⁵ : **H03M 1/06, H03M 1/74**

(21) Numéro de dépôt : **87402711.3**

(22) Date de dépôt : **01.12.87**

(54) **Convertisseur numérique-analogique pour circuit de génération d'images vidéo.**

(30) Priorité : **02.12.86 FR 8616805**

(43) Date de publication de la demande :
**06.07.88 Bulletin 88/27**

(45) Mention de la délivrance du brevet :
**10.04.91 Bulletin 91/15**

(84) Etats contractants désignés :
**DE FR GB IT NL**

(56) Documents cités :
**FR-A- 1 569 267**
**GB-A- 2 070 367**
**US-A- 4 068 140**
**PATENT ABSTRACTS OF JAPAN, vol. 7, no. 52
(E-162)[1197], 2 mars 1983; & JP-A-57 202 124**

(73) Titulaire : **SGS-THOMSON
MICROELECTRONICS S.A.
101 Boulevard Murat
F-75016 Paris (FR)**

(72) Inventeur : **Revol, Jean-Louis
THOMSON-CSF SCPI 19, avenue de Messine
F-75008 Paris (FR)**

(74) Mandataire : **de Beaumont, Michel
1bis, rue Champollion
F-38000 Grenoble (FR)**

## Description

Un convertisseur numérique-analogique pour circuit de génération d'images vidéo est destiné à fournir un signal analogique de commande des entrées de signal vidéo d'un téléviseur ou d'un moniteur. Ce signal analogique est l'un des signaux de chrominance ou luminance R, V, B.

Le signal produit par le convertisseur doit pouvoir piloter une impédance de charge de 75 ohms. Il doit de plus permettre le respect des diverses normes et en particulier offrir 1 volt de dynamique aux bornes de la charge. La norme n'impose pas le niveau haut ou bas à partir duquel s'étend cette dynamique de 1 volt, mais on verra ci-après quel est l'intérêt de se préoccuper en outre de ces niveaux.

Dans la conception du convertisseur intervient la technologie employée ; en technologie NMOS on ne dispose pas de sources de courant précises allant du potentiel le plus haut vers le potentiel le plus bas. Le convertisseur considéré ici, réalisé en technologie NMOS, sera donc un convertisseur fournissant une tension analogique plutôt qu'un courant.

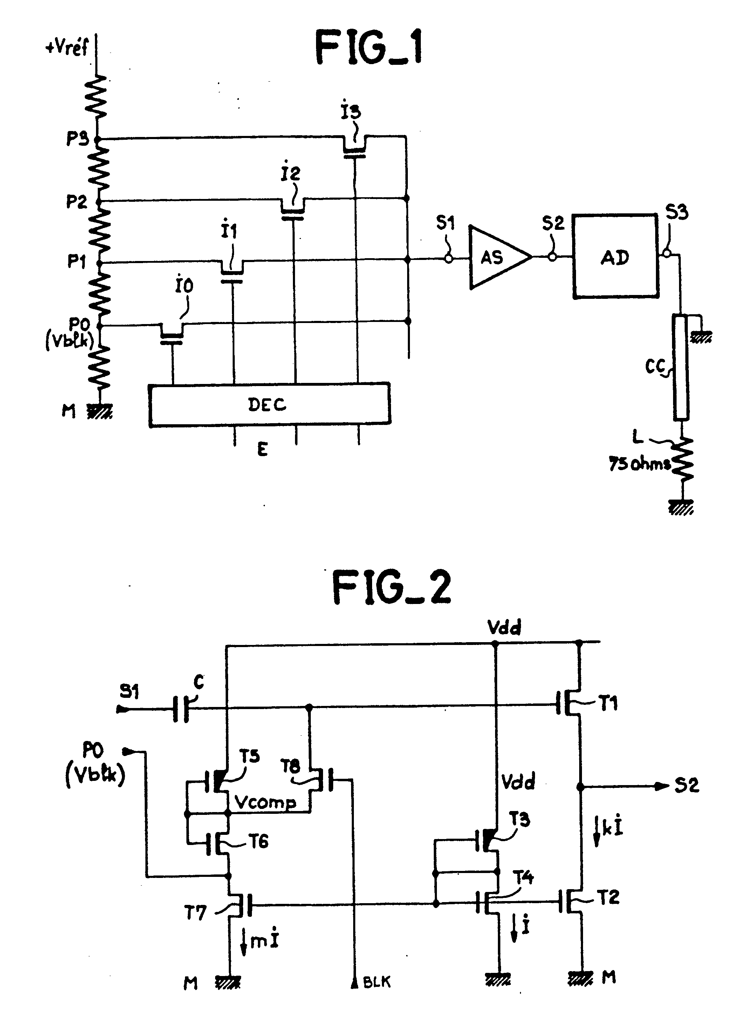

Un convertisseur numérique-analogique fournissant une tension est constitué généralement comme à la figure 1.

Il comprend un pont de résistances alimenté entre un potentiel haut + Vréf et un potentiel bas (masse M à 0 volt), le pont étant pourvu de prises P0, P1, P2... définissant des potentiels de référence qui sont des fractions du potentiel Vréf.

Un ensemble d'interrupteurs 10, 11, 12... relie respectivement chacune de ces prises à une entrée commune S1 d'un amplificateur suiveur AS.

Les interrupteurs sont commandés par un décodeur DEC ayant comme entrées un bus E sur lequel arrive un signal numérique à convertir en tension analogique.

L'amplificateur suiveur est un amplificateur à grande impédance d'entrée, pour éviter de dériver du courant du pont de résistances. Il a un gain unitaire et sa sortie S2, de faible impédance, est reliée à un adaptateur d'impédances AD servant à adapter l'impédance de sortie de l'amplificateur à l'impédance d'entrée de la charge (câble CC + moniteur). La sortie de l'adaptateur est désignée par S3.

L'adaptateur d'impédances, quel qu'il soit, introduit un facteur d'atténuation de 2 au moins.

Dans les convertisseurs de haut de gamme, un véritable amplificateur-suiveur contre-réactionné est prévu ; mais alors, la réponse en fréquence est limitée. De plus, on a besoin d'une alimentation en tension négative d'où un coût plus élevé et des problèmes de fiabilité.

Des convertisseurs de bas de gamme existent également. Ils sont de deux types.

Certains ne comportent pas d'amplificateur-suiveur ; ils ont d'ailleurs de ce fait une excellente précision et peuvent fonctionner avec une seule alimentation positive. Mais ils présentent une forte consommation dans le pont de résistances, ils nécessitent d'être connectés à des interfaces comprenant un amplificateur-suiveur, et il sera difficile d'obtenir une dynamique de 1 volt (après adaptateur d'impédances) quel que soit le type d'interface utilisé.

Certains autres convertisseurs de bas de gamme comportent bien un amplificateur-suiveur MOS dont l'élément principal est un transistor NMOS ayant son drain au potentiel d'alimentation du circuit intégré (en général Vcc = 5 volts), sa grille au point S1 de la figure 1 ; sa source sert de sortie reliée à un adaptateur d'impédances. L'inconvénient est qu'il est difficile d'obtenir la dynamique de sortie car la tension de seuil Vt des transistors formant les interrupteurs s'ajoute à la tension de seuil du transistor suiveur pour limiter la dynamique de tension possible vers le haut à Vcc - 2 Vt, soit une valeur qui peut descendre au dessous de 2 Volts si Vt atteint 1,5 Volts. Après passage dans l'adaptateur d'impédances, cette dynamique devient inférieure à 1 volt. De plus, le niveau bas de cette dynamique est fortement dépendant de la technologie (donc variable), alors qu'on peut souhaiter un offset constant de 0,7 à 0,8 volt dans les cas où on désire que l'étage suiveur en technologie NMOS puisse commander directement un autre étage suiveur en technologie bipolaire.

Le brevet US-A-4 459 553 décrit un circuit classique de compensation d'offset dans un amplificateur-suiveur comprenant :

- une entrée reliée à une première armature d'une capacité, l'autre armature étant reliée à l'entrée d'un étage amplificateur-suiveur comprenant au moins un premier transistor FET dont la grille constitue l'entrée de l'étage suiveur,

- un moyen pour charger la capacité à une tension égale à la tension grille-source du transistor.

L'abrégé des Patent Abstracts of Japan, volume 7, N° 52, 02.03.83, JP-A-57 202 124 décrit un circuit de conversion numérique/analogique dans lequel une procédure particulière est effectuée lors d'une phase particulière initiale pour tenir compte des valeurs minimale et maximale des tensions analogiques du circuit de conversion. Ce circuit est complexe et coûteux en surface de silicium, une fois intégré.

Pour éviter l'ensemble des inconvénients des dispositifs antérieurs, la présente invention propose un convertisseur numérique-analogique spécialement adapté à la commande d'un circuit de génération d'images vidéo, ce convertisseur utilisant de préférence les propriétés des signaux vidéo engendrés par ailleurs en dehors de la conversion numérique-analogique proprement dite.

Plus précisément, on sait que la génération d'images vidéo utilise un signal dit "signal d'extinction" ou "signal de blanking", pendant lequel le niveau de signal de chrominance ou de luminance est volontairement fixé à un niveau de potentiel bas tel que le spot de balayage de l'écran soit invisible et que le retour de ligne ou de trame de ce spot puisse s'effectuer sans engendrer une trace lumineuse sur l'écran.

Le convertisseur selon l'invention utilisera avec profit ce signal d'extinction.

On prévoit donc selon l'invention un convertisseur numérique-analogique comprenant un pont diviseur à prises multiples dont les prises définissent des potentiels de référence parmi lesquels un potentiel de référence bas, et des interrupteurs reliés chacun entre une prise respective et un noeud de circuit commun à tous les interrupteurs, ce noeud étant lui-même relié à un amplificateur suiveur de tension. L'amplificateur-suiveur comprend :

– une entrée reliée à une première armature d'une capacité, l'autre armature étant reliée à l'entrée d'un étage amplificateur-suiveur, cet étage comprenant au moins un transistor MOS dont la grille constitue l'entrée de l'étage suiveur et dont la source constitue la sortie de l'étage suiveur,

– un moyen pour charger la capacité à une tension égale à la tension grille-source du transistor pendant une période de temps au cours de laquelle le convertisseur fournit au noeud commun le potentiel de référence bas.

Cette période de temps est la durée du signal d'extinction du signal vidéo.

Pour charger la capacité à la tension indiquée, on applique pendant cette période une tension Vcomp sur le noeud reliant la capacité à la grille du transistor suiveur, cette tension Vcomp étant égale à la somme du potentiel de référence bas et de la tension grille-source du transistor.

Cette somme est établie par recopie, dans un transistor auxiliaire semblable au transistor-suiveur, des conditions de polarisation du transistor suiveur.

D'autres caractéristiques et avantages de l'invention apparaîtront à la lecture de la description détaillée qui suit et qui est faite en référence aux dessins annexés dans lesquels.

– La figure 1 déjà décrite représente la structure globale d'un convertisseur numérique-analogique tel qu'on en utilise dans les circuits de génération d'image vidéo ;

– la figure 2 représente le détail de l'amplificateur suiveur utilisé selon l'invention dans le schéma de la figure 1.

L'amplificateur suiveur de la figure 2 comprend donc une entrée S1 qui correspond à l'entrée S1 de la figure 1, et une sortie S2 qui correspond à celle de la figure 2.

Par ailleurs, cet amplificateur comporte deux autres entrées auxiliaires ; l'une est reliée à une prise P0 du pont diviseur, prise qui définit un potentiel de référence Vblk ; l'autre est une entrée recevant un signal logique de commande BLK qui définit un moment pendant lequel le potentiel Vblk doit être transmis en sortie du convertisseur.

On aura compris que le signal BLK est le signal de "blanking" ou d'extinction dans un circuit de génération d'image vidéo, et que le potentiel bas Vblk est le niveau de "surnoir" engendré par le convertisseur pendant le "blanking". Pour un circuit de génération de chrominance, les voies rouge, vert, bleu (comportant chacune leur convertisseur respectif) engendrent simultanément, pendant le blanking, des potentiels bas Vblk tels que la combinaison des couleurs engendrées sur l'écran soit un noir suffisamment intense (appelé "surnoir").

L'amplificateur est alimenté entre un potentiel d'alimentation haut Vdd et un potentiel d'alimentation bas Vss qui est en principe la masse du circuit de la figure 1.

L'élément principal de l'amplificateur est le transistor suiveur T1 ; c'est un transistor MOS à canal N; son drain est relié à Vdd, et sa source à la sortie S2 de l'amplificateur.

Le transistor T1 est chargé par un transistor T2, qui est un transistor Mos à canal N dont le drain est relié à la sortie S2, dont la source est à la masse, et dont la grille est polarisée par un étage de polarisation comprenant deux transistors T3 et T4.

L'étage de polarisation T3, T4, de l'étage suiveur T1, T2, est constitué de la manière suivante : T3 est un transistor à canal déplété ayant sa grille reliée à sa source ; il est donc normalement conducteur et constitue une résistance de charge pour T4 ; le drain de T3 est relié à Vdd, et sa source est reliée au drain de T4; T4 est un transistor normal (enrichi) ; il a sa grille reliée à son drain et également à la grille de T2 ; il a sa source reliée à la masse.

L'étage de polarisation T3, T4, est classique pour un étage suiveur à deux transistors T1, T2. Le courant I qui circule dans l'étage T3,T4, est recopié dans le transistor T2 avec un facteur multilplicatif k correspondant au rapport entre les tailles des transistors T2 et T4. Le rapport k est en principe supérieur à 1.

Selon l'invention, on prévoit les éléments supplémentaires suivants : une capacité C entre l'entrée S1 et la grille du transistor suiveur T1, trois transistors T5, T6, T7, définissant une tension de compensation Vcomp, et un transistor T8 commandé par le signal logique BLK pour appliquer cette tension de compensation à un moment choisi au point de jonction entre la capacité C et la grille du transistor T1. La capacité C est de préférence constituée par un transistor MOS, la grille constituant une première armature et le drain réuni à la source constituant la deuxième armature.

Le transistor T7 a sa source à la masse, et sa grille reliée à la grille des transistors T2 et T4. Il recopie donc le courant dans le transistor T2 avec un rapport m correspondant au rapport entre les tailles des transistors T7 et T4. Le rapport m est de préférence petit devant 1.

Le transistor T6 sert de charge au transistor T7 ; sa grille est reliée à son drain et sa source est reliée au drain du transistor T7. De plus, on prévoit que le transistor T6 est analogue au transistor suiveur T1, et que les tailles relatives de T6 et T1 sont dans le même rapport que les tailles relatives de T7 et T2.

Dans ces conditions, le potentiel grille-source du transistor T6 parcouru par le courant ml sera égal au potentiel grille-source du transistor T1 parcouru par le courant kl.

Le transistor T5 est un transistor déplété, qui a de préférence une taille relative par rapport au transistor T3 dans le même rapport k que la taille du transistor T7 par rapport au transistor T4. Ce transistor a sa grille reliée à sa source et au drain du transistor T6, et il a son drain relié au potentiel d'alimentation haut Vdd.

Le transistor T8, dont la grille est commandée par le signal BLK, a sa source reliée au point de jonction des transistors T5 et T6, et il a son drain relié au point de jonction de la capacité C et de la grille du transistor T1.

Enfin, la prise P0 du pont diviseur, fournissant le potentiel de référence Vblk, est reliée au point de jonction des transistors T6 et T7.

Le circuit fonctionne de la manière suivante :

Pendant l'apparition du signal BLK (à chaque retour ligne ou trame pour un convertisseur vidéo), le convertisseur transmet sur l'entrée S1 un potentiel Vblk ; autrement dit, l'interrupteur I0 de la figure 1 est fermé.

En même temps, le transistor T8 se ferme et relie le point de jonction de T6,T5 au point de jonction de la capacité C et du transistor T1.

La capacité C reçoit donc d'un côté le potentiel Vblk, et de l'autre un potentiel dit "potentiel de compensation" Vcomp présent à ce moment au point de jonction de T6 et T5.

Elle se charge donc à un potentiel égaé à Vcomp-Vblk.

Or pendant le signal BLK, le potentiel Vcomp est égal à la somme du potentiel Vblk (appliqué à la source de T6) et de la tension grille-source du transistor T6 ; on a expliqué ci-dessus que cette tension grille-source reproduisait la tension grille-source du transistor T1.

Il en résulte que la capacité C se charge à une valeur de potentiel égale à la tension grille-source du transistor T1 ; plus précisément, elle se charge à la valeur de tension grille-source qu'a le transistor T1 pendant le signal d'extinction BLK.

A la fin du signal d'extinction BLK, la capacité reste chargée à cette valeur car son armature reliée à la grille de T1 est isolée et ne peut se décharger.

Pendant les opérations de conversion qui sont exécutées ensuite, on voit que la tension de sortie en S2 est égale à la tension de sortie en S1, augmentée de la tension de charge de la capacité C et diminuée de la chute de tension grille-source du transistor T1. Bien que cette dernière tension ne soit pas nécessairement égale à ce qu'elle était pendant le signal BLK, elle en est très proche et le suiveur fournit sur la sortie S2 une tension très proche de la tension en S1.

On obtient donc une dynamique de sortie du convertisseur qui n'est pas détériorée par la présence du transistor suiveur T1.

On notera de plus que rien ne s'oppose alors à ce qu'on choisisse pour valeur de Vblk (non imposée par les normes) une valeur d'environ 0,75 volts, qui permet que la sortie S2 attaque directement un étage bipolaire.

## Revendications

1. Convertisseur numérique-analogique, comprenant un pont diviseur à prises multiples dont les prises définissent des potentiels de référence parmi lesquels un potentiel de référence déterminé (Vblk), et des interrupteurs (10, 11, 12, 13) reliés chacun entre une prise respective et un noeud de circuit (S1) commun à tous les interrupteurs, ce noeud étant lui-même relié à un amplificateur-suiveur de tension (AS), caractérisé en ce que l'amplificateur-suiveur comprend :

– une entrée reliée à une première armature d'une capacité (C), l'autre armature étant reliée à l'entrée d'un étage amplificateur-suiveur comprenant au moins un premier transistor MOS (T1) dont la grille constitue l'entrée de l'étage suiveur,
– un moyen pour charger la capacité à une tension égale à la tension grille-source du premier transistor (T1) pendant une période de temps au cours de laquelle le convertisseur fournit au noeud commun (S1) le potentiel de référence déterminé (Vblk).

2. Convertisseur selon la revendication 1, caractérisé en ce que l'étage suiveur comprend un deuxième transistor (T2) en série avec le premier transistor (T1), et en ce que les moyens pour charger la capacité comprennent un troisième transistor (T7) en série avec un quatrième transistor (T6), le troisième ayant sa grille et sa source reliées respectivement à la grille et à la source du deuxième, le quatrième ayant sa grille reliée à son drain, de manière à établir dans le troisième un courant proportionnel au courant dans le premier, les tailles relatives des premier et quatrième transistors étant dans le même rapport que les tailles relatives des deuxième et troisième transistors, de manière que la tension grille-source du quatrième transistor soit sensiblement identique à la tension grille-source du premier.

3. Convertisseur selon la revendication 2, caractérisé en ce qu'il est prévu un cinquième transistor (T8), commandé par un signal logique (BLK), pour relier le drain du quatrième transistor (T6) au point de jonction de la capacité (C) et de la grille du premier transistor, pendant que le potentiel de référence déterminé (Vblk) est appliqué au noeud commun (S1).

4. Convertisseur selon la revendication 3, caractérisé en ce que le point de jonction du troisième et du quatrième transistors est relié au potentiel de référence déterminé (Vblk).

## Ansprüche

1. Digital-Analog-Wandler, der umfaßt : Eine Teilerbrücke mit mehreren Abgriffpunkten, wobei die Abgriffpunkte der Brücke Bezugsspannungen festlegen, unter denen eine bestimmte Bezugsspannung (Vblk) ist, und mitSchaltern (10, 11, 12, 13), die jeweils zwischen einen entsprechenden Abgriffspunkt und einen Schaltungsanschluß (S1) geschaltet sind, welcher allen Schaltern gemeinsam ist, wobei der Anschluß selbst an einen Spannungsfolger-Verstärker (AS) angeschlossen ist, dadurch gekennzeichnet, daß der Spannungsfolger- Verstärker umfaßt :

– einen Eingangsanschluß, der an einen ersten Anschluß eines Kondensators (C) angeschlossen ist, wobei der andere Anschluß an den Eingangsanschluß einer Folgerverstärkerstufe angeschlossen ist, welche mindestens einen ersten MOS-Transistor (T1) umfaßt, dessen Gate den Eingangsanschluß der Folgerstufe darstellt ;

– eine Einrichtung zum Laden des Kondensators mit einer Spannung, die der Gate-Source-Spannung des ersten Transistors (T1) gleich ist, und zwar für .eine Zeitspanne, während derer der Wandler die bestimmte Bezugsspannung (Vblk) an den gemeinsamen Anschluß (S1) gibt.

2. Wandler nach Anspruch 1, dadurch gekennzeichnet, daß die Folgerstufe einen zweiten Transistor (T2) in Serie mit dem ersten Transistor (T1) umfaßt und daß die Einrichtung zum Laden des Kondensators einen dritten Transistor (T7) in Serie mit einem vierten Transistor (T6) umfaßt, wobei das Gate und die Source des dritten Transistors an das Gate bzw. die Source des zweiten Transistors und das Gate des vierten Transistors an den eigenen Drain angeschlossen sind, und zwar derart, daß in dem dritten Transistor ein Strom proportional zu dem Strom in dem zweiten Transistor erzeugt wird, wobei die relative Größe des ersten und des vierten Transistors im gleichen Verhältnis zueinander stehen, wie die relative Größe des zweiten und des dritten Transistors, so daß die Gate-Source-Spannung des vierten Transistors der Gate-Source-Spannung des ersten Transistors im wesentlichen gleich ist.

3. Wandler nach Anspruch 2, dadurch gekennzeichnet, daß ein fünfter Transistor (T8) vorgesehen ist, der von einem logischen Signal (BLK) angesteuert wird, um den Drain des vierten Transistors (T6) mit dem Verbindungspunkt des Kondensators (C) mit dem Gate des ersten Transistors zu verbinden, wenn die bestimmte Bezugsspannung (Vblk) an dem gemeinsamen Anschluß (S1) anliegt.

4. Wandler nach Anspruch 3, dadurch gekennzeichnet, daß der Verbindungspunkt zwischen dem dritten und dem vierten Transistor auf der bestimmten Bezugsspannung (Vblk) liegt.

## Claims

1. A digital-analog converter comprising a multipletap dividing bridge, the taps of which define reference voltages among which a determined reference voltage (Vblk), and switches (10, 11, 12, 13) each connected between a respective tap and a node of the circuit (S1) common to all switches, this node being in turn connected to a voltage follower (AS), characterized in this that said voltage follower comprises :

– an input connected to a first end of a capacitor (C), the other end being connected to the input of a follower stage comprising at least a first MOS transistor (T1), the gate of which constitutes the input of the follower stage,

– means for charging the capacitor at a voltage equal to the gate-source voltage of the first transistor (T1) for a period of time during which the converter supplies the determined reference voltage (Vblk) to the common node (S1).

2. A converter according to claim 1, characterized in this that the follower stage comprises a second transistor (T2) in series with the first transistor (T1), and in this that said means for charging the capacitor comprise a third transistor (T7) in series with a fourth transistor (T6), the third transistor having its gate and source respectively connected to the gate and source of the second transistor, the fourth transistor having its gate connected to its drain, so as to establish in the third transistor a current proportional to the current in the first transistor, the relative size of the first and fourth transistors being in the same ratio as the relative size of the second and third transistors, so that the gate-source voltage of the fourth transistor is substantially identical to the gate-source voltage of the first transistor.

3. A converter according to claim 2, characterized in this that a fifth transistor (T8) controlled by a logic signal (BLK) is provided for connecting the drain of the fourth transistor (T6) to the junction between the capacitor (C) and the gate of the first transistor, when the determined reference voltage (Vblk) is applied to the common node (S1).

4. A converter according to claim 3, characterized in this that the junction of the third and fourth transistors is connected to the determined reference voltage (Vblk).

# FIG_1

# FIG_2